# EUROPEAN PATENT APPLICATION

(11) **EP 3 525 245 A1**
(43) Date of publication of application: **14.08.2019**
(21) Application number: 18857413.1
(22) Date of filing: 26.09.2018
(51) Int. Cl.: H01L 31/05

(54) **BATTERY PIECE SERIAL CONNECTION ASSEMBLY**

(30) Priority: 27.09.2017 CN 201710888261
(71) Applicant: Zhejiang Jinko Solar Co., Ltd., Haining, Zhejiang 314416 (CN); JINKO SOLAR CO., LTD, Shangrao, Jiangxi 334100 (CN)
(72) Inventor: WANG, Juan, Haining Zhejiang 314416 (CN); LIU, Yafeng, Haining Zhejiang 314416 (CN); JIN, Hao, Haining Zhejiang 314416 (CN)
(74) Representative: Detken, Andreas
(86) International application number: PCT/CN2018/107588
(87) International publication number: WO 2019/062758

(57) **Abstract**

A series-connected solar cell module is provided, which includes multiple solar cell units. each of the multiple solar cell units comprises multiple solar cells. In each of the multiple solar cell units, a back surface of one of two adjacent solar cells is electrically connected to a front surface of the other of the two adjacent solar cells through a conductive material. A first insulating layer and a second insulating layer are provided at positions where the conductive material is in close contact with the two adjacent solar cells. Therefore, adjacent solar cells can be arranged in close contact with each other, to achieve a seamless contact, thereby increasing the effective area of the series-connected solar cell module.

## Description

The present application claims priority to Chinese Patent Application No. 201710888261.5, titled "SERIES-CONNECTED SOLAR CELL MODULE", filed on September 27, 2017 with the Chinese Patent Office, which is incorporated herein by reference in its entirety.

### FIELD

The present disclosure relates to the technical field of photovoltaics, and in particular to a series-connected solar cell module.

### BACKGROUND

Installations of photovoltaics are growing rapidly all across the world. However, land that can be used for deploying photovoltaics is decreasing. Therefore, there is an increasing market demand for efficient photovoltaic modules. Currently, photovoltaic modules are mainly formed by single crystalline silicon solar cells or polycrystalline silicon solar cells which are connected in series via solder ribbons.

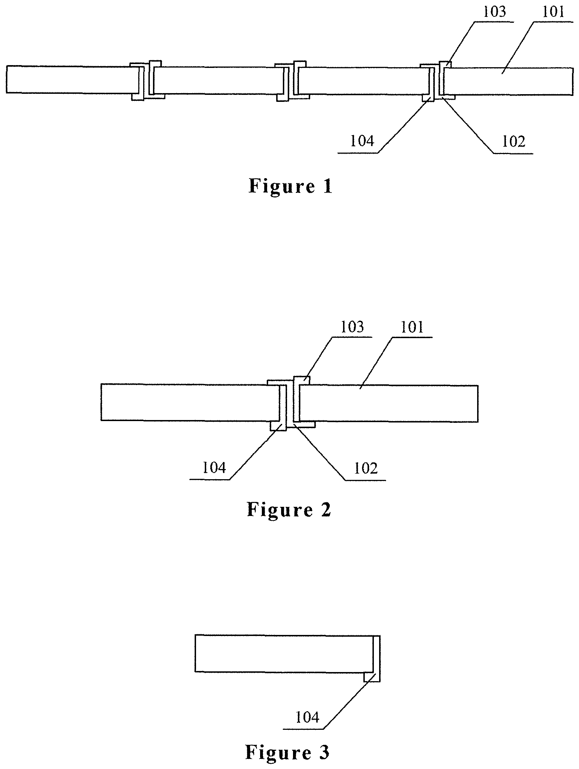

Reference is made to Figure 1, which is a schematic structural diagram of a series-connected solar cell module in the conventional technology.

The series-connected solar cell module is produced by using series welding. Specifically, solder ribbons, which have the same width, are grouped into an upper group and a lower group, each including the same number of solder ribbons. The two groups of solar ribbons are stacked to from a solder ribbon mesh. Solar cells are arranged between the upper group of solder ribbons and the lower group of solder ribbons, with the solder ribbons being aligned with the main grid lines of the solar cells. The upper group of solder ribbons are welded to the front surfaces of the solar cells, and the lower group of solder ribbons are welded to the back surfaces of the solar cells. The upper group of solder ribbons are welded to the lower group of solder ribbons with contact pads located between two adjacent solar cells. The solder ribbon connected to the front surface of one of the two adjacent solar cells is cut off, and the solder ribbon connected to the back surface of the other of the two adjacent solar cells is cut off, to form a solar cell string including two solar cells which are connected in series. In order to prevent the contact pads from contacting with the back surfaces of solar cells of which the front surfaces are welded to the solder ribbons or the front surfaces of solar cells of which the back surfaces are welded to the solder ribbons, gaps are provided between adjacent solar cells, which results in a reduction in efficiency of the series-connected solar cell module.

Therefore, how to increase the effective area of the series-connected solar cell module becomes an urgent problem to be solved by those skilled in the art.

### SUMMARY

In view of the above, how to increase the effective area of the series-connected solar cell module is an urgent problem to be solved by those skilled in the art. To address this problem, a series-connected solar cell module is provided according to the present disclosure.

In order to achieve the aforementioned object, the following technical solutions are provided according to the present disclosure.

A series-connected solar cell module is provided, which includes multiple solar cell units. Each of the multiple solar cell units includes multiple solar cells. In each of the multiple solar cell units, a back surface of one of two adjacent solar cells is electrically connected to a front surface of the other of the two adjacent solar cells through a conductive material. A first insulating layer and a second insulating layer are provided at positions where the conductive material is in close contact with the two adjacent solar cells.

Preferably, in the aforementioned series-connected solar cell module, the conductive material includes a connection portion located between the two adjacent solar cells, a first conductive portion connected to the back surface of one of the two adjacent solar cells, and a second conductive portion connected to a back surface of the other of the two adjacent solar cells.

Preferably, in the aforementioned series-connected solar cell module, the first conductive portion and the second conductive portion are perpendicular to the connection portion.

Preferably, in the aforementioned series-connected solar cell module, each of the first insulating layer and the second insulating layer is a part of the connection portion.

Preferably, in the aforementioned series-connected solar cell module, the first insulating layer and the second insulating layer are arranged on solar cells.

Preferably, in the aforementioned series-connected solar cell module, the multiple solar cell units are arranged in parallel in a width direction of the multiple solar cell units.

Preferably, in the aforementioned series-connected solar cell module, the multiple solar cell units are arranged in parallel in a length direction of the multiple solar cell units.

Preferably, in the aforementioned series-connected solar cell module, a junction box of the solar cell module is provided in the middle of the multiple solar cell units.

As can be seen form the aforementioned technical solutions, since the first insulating layer and the second insulating layer are provided at positions where the conductive material is in close contact with the two solar cells according to the embodiment of the present disclosure, the adjacent solar cells can closely contact with each other, such that a seamless contact is achieved, thereby increasing the effective area of the series-connected solar cell module.

### BRIEF DESCRIPTION OF THE DRAWINGS

In order to more clearly illustrate technical solutions in embodiments of the present disclosure or in the conventional technology, the drawings to be used in the description of the embodiments or the conventional technology are briefly described hereinafter. Apparently, the drawings in the following description show only some embodiments of the present disclosure, and other drawings may be obtained by those skilled in the art from the drawings without any creative work.
Figure 1 is a schematic structural diagram of a solar cell unit according to an embodiment of the present disclosure;
Figure 2 is a schematic diagram showing connection between two adjacent solar cells according to an embodiment of the present disclosure;
Figures 3 and 4 are schematic structural diagrams of solar cells according to embodiments of the present disclosure;
Figure 5 is a plan view of a solar cell unit according to an embodiment of the present disclosure;
Figure 6 is a schematic structural diagram of a series-connected solar cell module according to an embodiment of the present disclosure;
Figure 7 is a schematic structural diagram of a series-connected solar cell module according to another embodiment of the present disclosure; and
Figure 8 is a schematic structural diagram of a series-connected solar cell module according to another embodiment of the present disclosure.

In the drawings, 100 denotes a solar cell unit, 101 denotes a solar cell, 102 denotes a conductive material, 103 denotes a first insulating layer, and 104 denotes a second insulating layer.

### DETAILED DESCRIPTION OF THE EMBODIMENTS

The present disclosure aims to provide a series-connected solar cell module with an increased effective area.

Hereinafter, embodiments are illustrated with reference to the drawings. Embodiments described hereinafter do not limit the invention presented in the claims. Furthermore, all of those described in the embodiments are not always essential to technical solutions of the present disclosure presented in the claims.

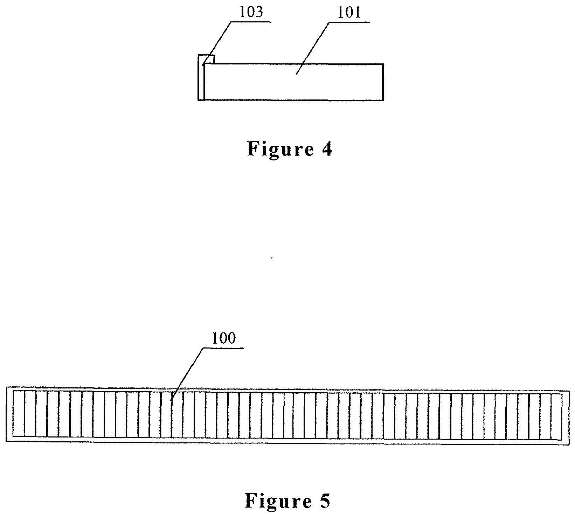

Reference is made to Figures 1 to 5. According to an embodiment of the present disclosure, the series-connected solar cell module includes multiple solar cell units, and each of the multiple solar cell units includes multiple solar cells 101. In each of the multiple solar cell units, a back surface of one of two adjacent solar cells 101 is electrically connected to a front surface of the other of the two adjacent solar cells through a conductive material 102. A first insulating layer 103 and a second insulating layer 104 are provided at positions where the conductive material 102 is in close contact with the two adjacent solar cells 101.

According to the embodiment of the present disclosure, since the first insulating layer 103 and the second insulating layer 104 are provided at positions where the conductive material 102 is in close contact with the two solar cells 101, the two adjacent solar cells 101 can be arranged in close contact with each other, such that a seamless contact is achieved, thereby increasing the effective area of the series-connected solar cell module.

In addition, according to the embodiment of the present disclosure, the adjacent solar cells 101 in the solar cell unit are in close contact with each other but do not overlap, such that cracks in solar cells 101 can be avoided.

According to the embodiment of the present disclosure, the conductive material 102 includes a connection portion located between the two adjacent solar cells 101, a first conductive portion connected to the back surface of one of the two adjacent solar cells 101, and a second conductive portion connected to a back surface of the other of the two adjacent solar cells 101.

In order to further ensure the close contact between the two adjacent solar cells 101, the first conductive portion and the second conductive portion are perpendicular to the connection portion.

Each of the first insulating layer 103 and the second insulating layer 104 is a part of the connection portion. Alternatively, the first insulating layer 103 and the second insulating layer 104 are provided on solar cells 101.

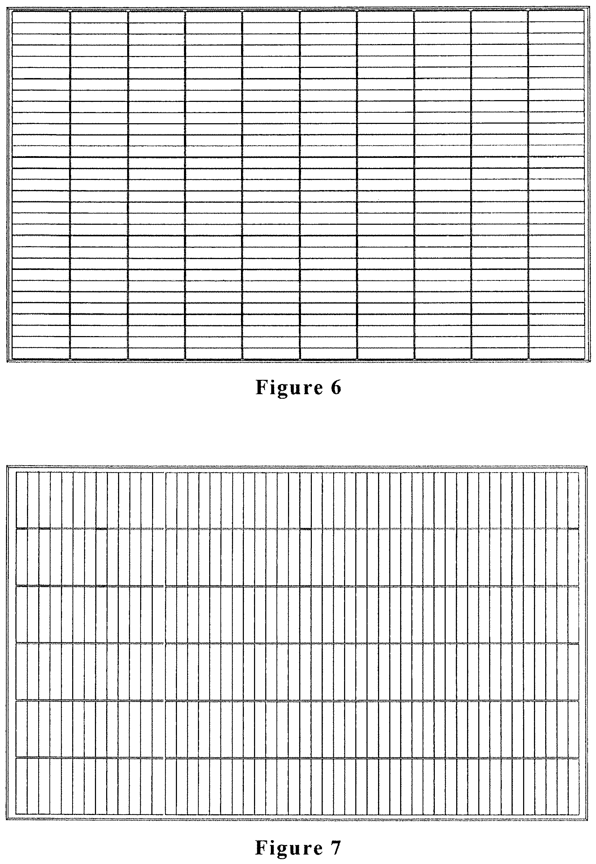

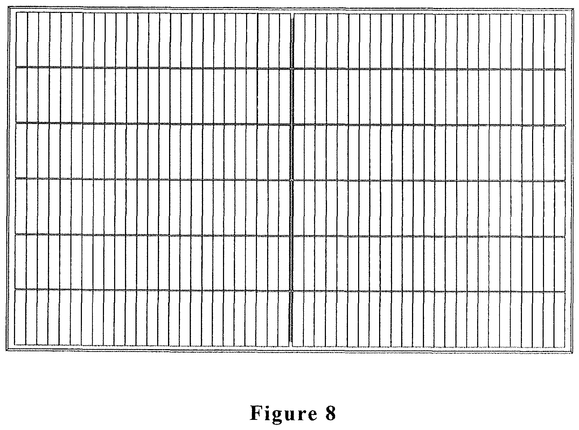

There are various arrangements of the aforementioned solar cell units. Referring to Figure 6, multiple solar cell units are arranged in parallel in a width direction of the multiple solar cell units. Referring to Figure 7, multiple solar cell units are arranged in parallel in a length direction of the multiple solar cell units. Referring to Figure 8, a junction box of the solar cell 101 module being provided in the middle of multiple solar cell units.

The above illustration of the disclosed embodiments enables those skilled in the art to implement or practice the present disclosure. Many changes to these embodiments are apparent for those skilled in the art, and general principles defined herein can be implemented in other embodiments without departing the spirit or scope of the present disclosure. Hence, the present disclosure is not limited to the embodiments disclosed herein, but is to conform to the widest scope consistent with principles and novel features disclosed herein.

## Claims

1. A series-connected solar cell module, comprising:
a plurality of solar cell units (100), wherein
each of the plurality of solar cell units (100) comprises a plurality of solar cells;
in each of the plurality of solar cell units (100), a back surface of one of two adjacent solar cells is electrically connected to a front surface of the other of the two adjacent solar cells through a conductive material (102); and
a first insulating layer (103) and a second insulating layer (104) are provided at positions where the conductive material (102) is in close contact with the two adjacent solar cells.

2. The series-connected solar cell module according to claim 1, wherein the conductive material (102) comprises a connection portion located between the two adjacent solar cells, a first conductive portion connected to the back surface of one of the two adjacent solar cells, and a second conductive portion connected to a back surface of the other of the two adjacent solar cells.

3. The series-connected solar cell module according to claim 2, wherein the first conductive portion and the second conductive portion are perpendicular to the connection portion.

4. The series-connected solar cell module according to claim 2, wherein each of the first insulating layer (103) and the second insulating layer (104) is a part of the connection portion.

5. The series-connected solar cell module according to claim 2, wherein the first insulating layer (103) and the second insulating layer (104) are arranged on solar cells.

6. The series-connected solar cell module according to claim 1, wherein the plurality of solar cell units (100) are arranged in parallel in a width direction of the plurality solar cell units (100).

7. The series-connected solar cell module according to claim 1, wherein the plurality of solar cell units (100) are arranged in parallel in a length direction of the plurality solar cell units (100).

8. The series-connected solar cell module according to claim 1, wherein a junction box of the solar cell module is provided in the middle of the plurality of solar cell units (100).
